## Europäisches Patentamt
## European Patent Office
## Office européen des brevets

(19)

(11) Veröffentlichungsnummer : **0 012 899**
**B1**

(12) **EUROPÄISCHE PATENTSCHRIFT**

(45) Veröffentlichungstag der Patentschrift :
05.10.83

(51) Int. Cl.³ : **H 03 L 7/18**

(21) Anmeldenummer : 79104993.5

(22) Anmeldetag : 07.12.79

(54) **Digitale Phasenregelschaltung mit einer Hilfsschaltung.**

(30) Priorität : 27.12.78 DE 2856211

(43) Veröffentlichungstag der Anmeldung :
09.07.80 Patentblatt 80/14

(45) Bekanntmachung des Hinweises auf die Patenterteilung : 05.10.83 Patentblatt 83/40

(84) Benannte Vertragsstaaten :
**AT BE CH DE FR GB IT LU NL SE**

(56) Entgegenhaltungen :
**DE A 1 462 500**
**FR A 2 194 075**
**US A 3 164 777**
**US A 3 939 438**

(73) Patentinhaber : **Licentia Patent-Verwaltungs-GmbH
Theodor-Stern-Kal 1
D-6000 Frankfurt/Main 70 (DE)**

(72) Erfinder : **Streckenbach, Wulf-Christian Dipl.-Ing.
Deveserstrasse 1A
D-3005 Hemmingen 1 (DE)** .

(74) Vertreter : **Einsei, Robert, Dipl.-Ing.
Theodor-Stern-Kal 1
D-6000 Frankfurt/Main 70 (DE)**

Digitale Phasenregelschaltung mit einer Hilfsschaltung

Die Erfindung betrifft eine digitale Phasenregelschaltung nach dem Oberbegriff des Anspruchs 1. Digitale Phasenregelschaltungen weisen bekanntlich einen steuerbaren Oszillator, einen programmierbaren Teiler, eine Referenzfrequenzquelle, einen Phasendiskriminator und eine Tiefpaß- bzw. Integrierschaltung auf. Das Ausgangssignal des steuerbaren Oszillators wird dem einen Eingang des Phasendiskriminators über den programmierbaren Teiler zugeführt, während dem anderen Eingang des Phasendiskriminators das Signal der Referenzfrequenzquelle zugeführt wird. Aus dem Ausgangssignal des Phasendiskriminators wird mittels der Tiefpaßschaltung ein Steuersignal gewonnen, mit dem der steuerbare Oszillator gesteuert wird. Die Signale am Ausgang des Phasendiskriminators weisen Rechteckimpulse auf. Der Gleichspannungsmittelwert der Rechteckimpulse wird mittels der nachgeschalteten Filterschaltung gewonnen und dient als Stellgröße für den steuerbaren Oszillator. Die Schaltung regelt sich so ein, daß im stationären Zustand die am Phasendiskriminator anliegenden Signale bezüglich Frequenz und Phasen übereinstimmen.

Um ein zu starkes Überschwingen des steuerbaren Oszillators zu verhindern, ist eine gewisse Mindestzeitkonstante der beispielsweise als aktiver Integrator ausgebildeten Filterschaltung erforderlich. Dadurch ergibt sich für das gesamte System eine relativ große Zeitkonstante, die sich in vielen Fällen störend bemerkbar macht. Eine hohe Zeitkonstante kann z. B. die Schwingneigung der Gesamtschaltung erhöhen.

In der DE-A 27 51 021 ist eine digitale Phasenregelschaltung beschrieben, die dazu dient, das Signal des steuerbaren Oszillators der Phasenregelschaltung mit einem extern zugeführten Bezugssignal zu synchronisieren. Das Signal des Oszillators wird bei dieser bekannten Schaltung bezüglich der Frequenz in einem Teiler mit festem Teilungsverhältnis heruntergeteilt. Das heruntergeteilte Signal wird dann im Phasendiskriminator mit dem Bezugssignal verglichen. Es ist eine Zusatzschaltung vorgesehen, mittels der nach der Einschaltung des externen Bezugssignals der Teiler zunächst in einem definierten Ausgangszustand gehälten und anschließend, gesteuert von dem nächsten Impuls des Bezugssignals, für die Teilerfunktion freigegeben wird.

Diese Freigabe zu einem definierten Zeitpunkt findet jeweils nur einmal unmittelbar nach der Einschaltung des externen Bezugssignals statt. Durch diese Maßnahme wird die Einstellzeit der Regelschaltung verkürzt.

Weiter ist durch die CH-A 364 818 eine digitale Phasenregelschaltung bekannt, bei der zwischen dem Ausgang eines steuerbaren Oszillators und einem ersten Eingang eines Phasendiskriminators ein erster Frequenzteiler mit festem Teilungsverhältnis und zwischen der Referenzfrequenzquelle und dem anderen Eingang des Phasendiskriminators ein zweiter Frequenzteiler mit ebenfalls festem Teilungsverhältnis vorgesehen sind. Bei dieser bekannten Schaltung ist eine Hilfsschaltung vorgesehen, die vom Ausgang des Phasendiskriminators gesteuert wird und in der vom Ausgangssignal des Phasendiskriminators im Falle eines Phasenfehlers ein Synchronisiersignal abgeleitet wird, mit dem der Teiler der Referenzfrequenzquelle oder der mit dem steuerbaren Oszillator verbundene Teiler in einen definierten Ausgangszustand setzbar sind. Die Hilfsschaltung spricht erst bei einer Phasenabweichung von beinahe 90° der im Phasendiskriminator verglichenen Signale an. Die Hilfsschaltung ist so mit den Teilern gekoppelt, daß bei derjenigen Regelrichtung des Oszillators, bei der die Frequenz des Oszillators abnimmt, der der Referenzfrequenzquelle zugeordnete Teiler und bei der anderen Regelrichtung, bei der die Frequenz des Oszillators zunimmt, der dem steuerbaren Oszillator zugeordnete Teiler jeweils in einen definierten Ausgangszustand gesetzt werden.

Diese bekannte Schaltung eignet sich nicht für den Aufbau einer Frequenzsyntheseschaltung, bei der derjenige Teiler, der dem steuerbaren Oszillator zugeordnet ist, als ein programmierbarer Teiler ausgeführt ist. Bei einer Schaltung der zuletzt genannten Art, von der bei der Erfindung ausgegangen wird, ändert die Frequenz des dem Phasendiskriminator vom steuerbaren Oszillator über den programmierbaren Teiler zugeführten Signales sich schlagartig, wenn das Teilungsverhältnis des programmierbaren Teilers umgeschaltet wird.

Bei der Schaltung gemäß CH-A 364 818 enthält das Ausgangssignal des Phasendiskriminators in dem Augenblick, in dem die Hilfsschaltung anspricht, keine Information mehr über das Maß der Phasenabweichungen der im Phasendiskriminator verglichenen Signale. Ein Überschwingen der Regelschaltung kann aus diesem Grunde nicht in befriedigendem Maße vermindert werden, wenn man die bekannte Maßnahme bei einer Regelschaltung mit einem programmierbaren Teiler anwenden würde.

Der Erfindung liegt die Aufgabe zugrunde, bei einer Phasenregelschaltung mit einem programmierbaren Teiler zwischen dem Ausgang des steuerbaren Oszillators und dem Phasendiskriminator eine Hilfsschaltung so vorzusehen, daß die Einstellzeit nach einer Umschaltung des Teilungsverhältnisses des programmierbaren Teilers wesentlich verkürzt ist.

Bei der erfindungsgemäßen Anordnung werden gerade entgegen der Lehre der CH-A 364 818 bei derjenigen Regelrichtung des Oszillators, bei der die Frequenz des Oszillators abnimmt, der dem Oszillator zugeordnete programmierbare Teiler und bei der anderen Regelrichtung, bei der die Frequenz des Oszillators zunimmt, der Teiler der Referenzfrequenzquelle in einen definierten Ausgangszustand gesetzt. Zusätzlich ist die Maßnahme getroffen, daß der in den Ausgangszustand gesetzte Teiler so lange in diesem Zustand gehalten wird, bis der andere nicht beeinflußte Teiler seinen Ausgangszustand erreicht hat.

Durch diese Maßnahme in dieser Kombination wird erreicht, daß bei jedem Vergleichszyklus ein echter Phasen- bzw. Frequenzvergleich der beiden zu vergleichenden Signale durchgeführt wird. Jeweils zu Beginn des Vergleichszyklusses wird die Phasendifferenz Null neu definiert. Die Hilfsschaltung wirkt so, daß die am Ende eines jeden Vergleichszyklusses vorliegende Phasenabweichung der beiden am Phasendiskriminator anliegenden Signale der tatsächlichen Phasenabweichung der zu vergleichenden Signale entspricht. Auf diese Weise werden dem steuerbaren Oszillator jederzeit Nachstellsignale zugeführt, die der tatsächlichen Phasenabweichung entsprechen. Diese Eigenschaft, die für die Verhinderung von Überschwingen bei einem Regelvorgang gerade ausschlaggebend ist, weist die bekannte Schaltung gemäß CH-A 364 818 nicht auf. Bei der erfindungsgemäßen Schaltung nimmt während eines Nachregelvorganges nach einer Umschaltung des Teilungsverhältnisses die Phasenabweichung der im Phasendiskriminator verglichenen Signale zueinander stetig ab, so daß Frequenz und Phasengleichheit gleichzeitig erreicht werden, wodurch ein Überschwingen vermieden ist.

Aus der FR-A 2 194 075 ist eine Phasenregelschaltung bekannt, bei der die Zähler nicht gleich angehalten werden, womit eine Überreaktion vermieden wird. Diese Regelschaltung benötigt eine gewisse Zeit, um auf eine veränderte Einstellung zu reagieren. Dies ist insbesondere dadurch verursacht, daß die Referenzzeit der Regelschaltung nicht beliebig klein ist.

Ziel der Erfindung ist es, eine solche Phasenregelschaltung derart zu gestalten, daß das Einschwingen nach einer Neueinstellung der Teiler möglichst schnell aber ohne Überschwingen stattfindet. Dies wird bei einer Phasenregelschaltung nach der Gattung des Anspruchs 1 durch die Merkmale im Kennzeichen des Anspruchs 1 erreicht.

Die erfindungsgemäße Phasenregelschaltung ist besonders gut für Frequenzsynthesizer geeignet.

Zum besseren Verständnis der Erfindung wird im folgenden anhand der Zeichnung erläutert, wie eine Schaltung mit den erfindungsgemäßen Merkmalen beispielsweise aufgebaut werden kann.

Es zeigen

Figur 1 eine Phasenregelschaltung mit den erfindungsgemäßen Merkmalen,

Figuren 2 und 3 Ausgangssignale eines Phasendiskriminators bei Phasenregelschaltungen, die nach dem Stand der Technik aufgebaut sind, für die beiden verschiedenen Richtungen der Regelung,

Figur 4 ein Impulsdiagramm der Signale bei einer Phasenregelschaltung mit den Merkmalen der Erfindung für eine Richtung der Regelung,

Figur 5 der Figur 4 entsprechende Signale für die andere Richtung der Regelung,

Figur 6 die mit der Schaltung nach Fig. 1 erzielte Wirkung,

Figur 7 ein Ausführungsbeispiel einer in Fig. 1 vorgesehenen Hilfsschaltung und

Figur 8 einen Fernsehtuner, der nach dem in Fig. 1 gezeigten Prinzip aufgebaut ist.

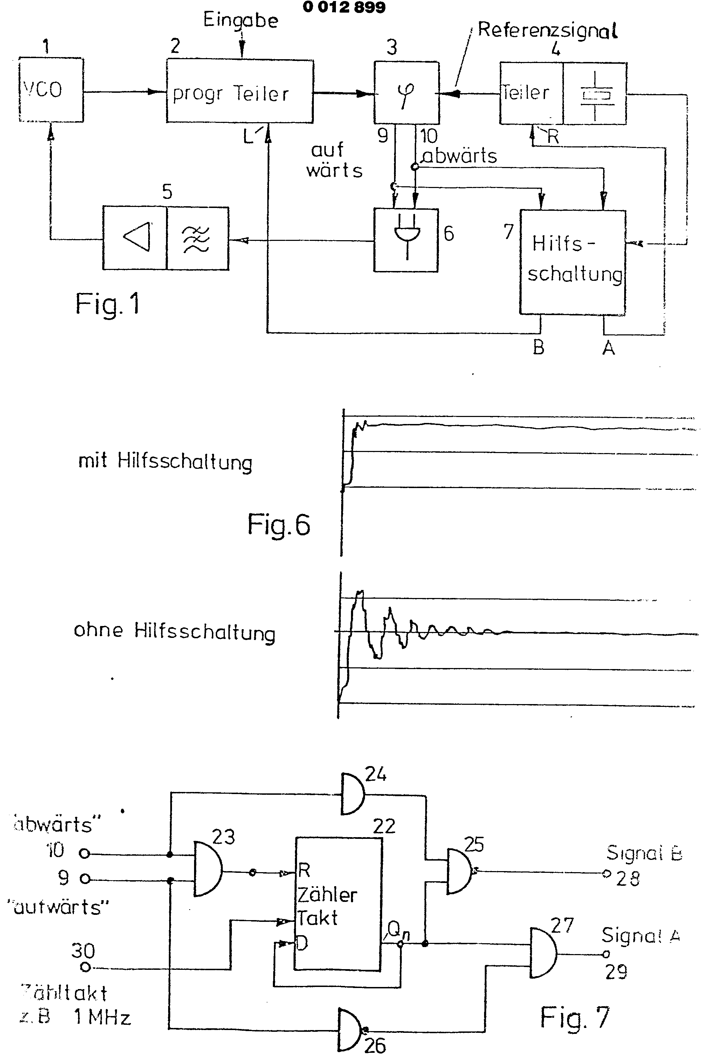

In Fig. 1 ist eine Phasenregelschaltung dargestellt mit einem steuerbaren Oszillator 1 (VCO), einem programmierbaren Teiler 2, einer Referenzquelle 4, einem Phasendiskriminator 3, einer Verknüpfungsschaltung 6 und einer Tiefpaß- und Verstärkerschaltung 5. Die genannten Teile sind in an sich bekannter Weise zu einer Regelschleife zusammengeschaltet. Der programmierbare Teiler kann auf verschiedene Teilungsverhältnisse eingestellt werden, wodurch die Ausgangsfrequenz des steuerbaren Oszillators 1 vorgegeben wird. Dem programmierbaren Teiler können nach feste Vorteiler vorgeschaltet sein (nicht dargestellt). Die Referenzfrequenzquelle 4 besteht aus einem Quarzoszillator und einem nachgeschalteten Frequenzteiler mit einem beispielsweise fest vorgegebenen Teilungsverhältnis. Das Ausgangssignal des Teilers ist dem Phasendiskriminator 3 als Referenzsignal zugeführt.

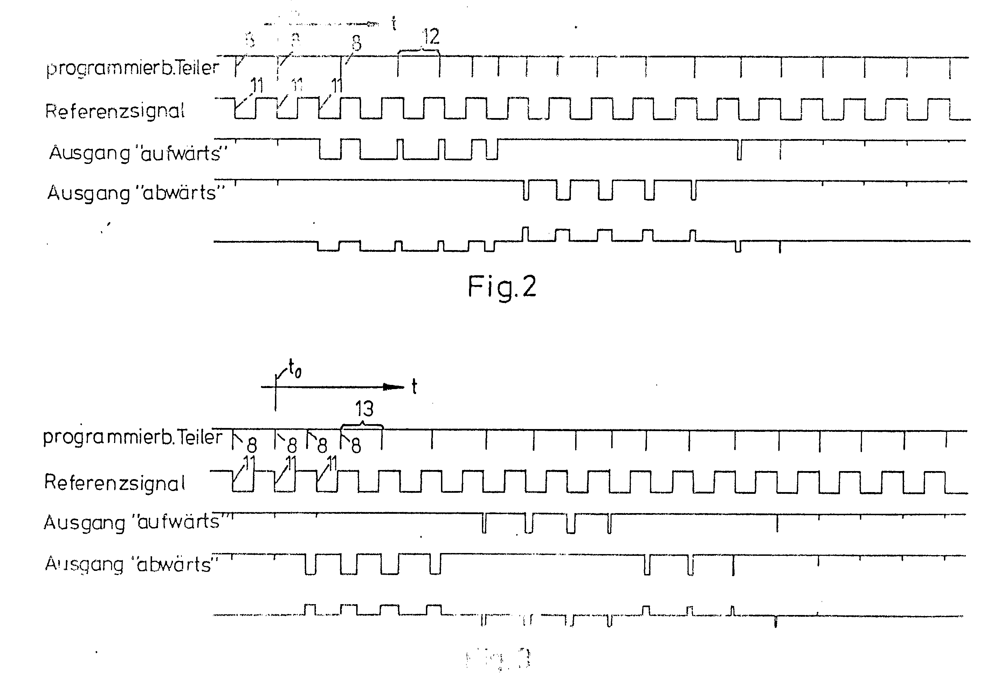

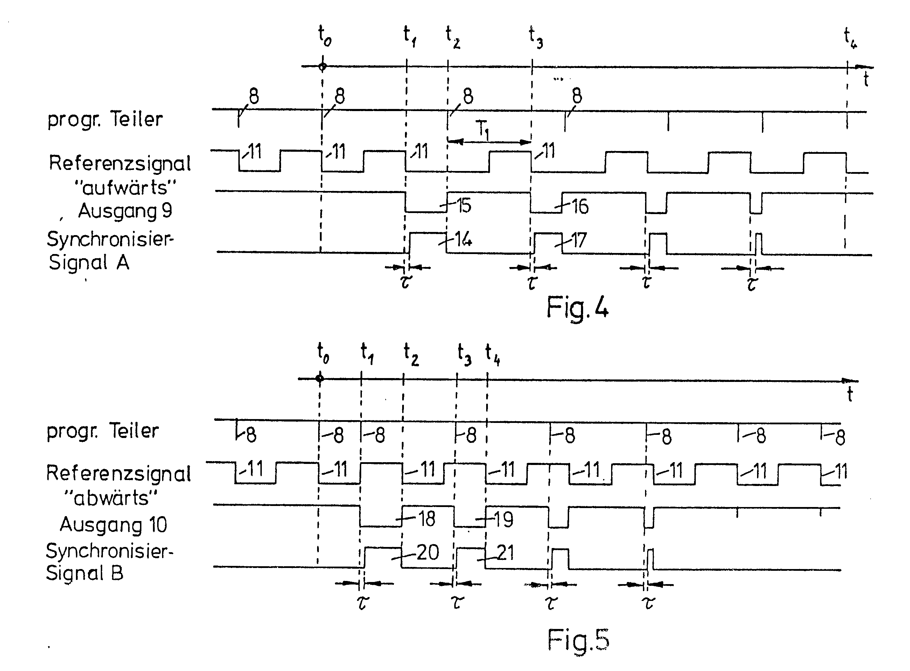

Bevor auf die in Fig. 1 dargestellte Hilfsschaltung 7 eingegangen wird, sei zunächst anhand der Figuren 2 und 3 erläutert, wie Phasenregelschaltungen an sich bekannter Bauart arbeiten. Zugrundegelegt ist eine Schaltung entsprechend Fig. 1 jedoch ohne die Hilfsschaltung 7.

In Fig. 2 oben ist das Ausgangssignal des programmierbaren Teilers 2 dargestellt. Nach jedem Durchlauf des programmierbaren Teilers 2 erscheint am Ausgang des Teilers ein negativer Impuls 8, der dem Phasendiskriminator 3 zugeführt wird. In der zweiten Zeile in Fig. 2 ist das Referenzsignal dargestellt, das dem anderen Eingang des Phasendiskriminators 2 in Fig. 1 zugeführt wird.

Der Phasendiskriminator 3 in Fig. 1 weist einen Ausgang 9 auf, an dem bei einer Regelung des Oszillators 1 in Aufwärtsrichtung Steuerimpulse auftreten, und einen Ausgang 10, an dem Impulse bei einer Regelung in Abwärtsrichtung auftreten. Die Ausgangssignale dieser Ausgänge 9 und 10 sind in der dritten und vierten Zeile in Fig. 2 dargestellt. In der letzten Zeile ist ein mittels der Verknüpfungsschaltung 6 gewonnenes sogenanntes « Tristate-Signal » wiedergegeben, das der Tiefpaß-Schaltung zugeführt wird. Bei dem in Fig. 2 dargestellten Diagramm ist ein Phasendiskriminator vom sogenannten Typ 4 zugrundegelegt (siehe Buch von Horst Geschwinde « Einführung in die PLL-Technik », Verlag Vieweg, Seite 19). Jedem Ausgang (9 bzw. 10) des Phasendiskriminators ist der Ausgang einer bistabilen Schaltung zugeordnet. Der Phasendiskriminator ist im dargestellten Fall so aufgebaut, daß die bistabilen Schaltungen auf die negative Flanke 11 des Referenzsignals bzw. die negative Flanke des vom programmierten Teiler 2 kommenden Impulse 8 ansprechen. Sie ist weiter so aufgebaut, daß bei einer Abweichung der Phasen der an dem Phasendiskriminator 3 anliegenden Signale je nach Richtung der Abweichung entweder an dem einen Ausgang 9 « aufwärts » oder an dem anderen Ausgang 10 « abwärts » Impulse auftreten. Die dem Ausgang « aufwärts » zugeordnete bistabile Schaltung ist durch die Flanken 11 des Referenzsignals setzbar und durch die Impulse 8, die vom programmierbaren Teiler 2 kommen, rücksetzbar. Dagegen ist die dem Ausgang « abwärts » zugeordnete bistabile Schaltung im Phasendiskriminator gerade umgekehrt durch die vom programmierbaren Teiler 2 kommenden Impulse 8 setzbar und durch die Flanken 11 des Referenzsignals rücksetzbar. In Fig. 2 sind die Signale dargestellt für den Fall, daß zum Zeitpunkt to das Teilungsverhältnis des programmierbaren Teilers 2 auf einen höheren Wert umgeschaltet wird. Infolgedessen wird die Frequenz des Oszillators 1 zu höheren Frequenzen hin nachgeregelt, was in Fig. 2 daran zu erkennen ist, daß die Impulse 8 am Ausgang des programmierbaren Teilers nach der Eingabe des neuen Teilungsverhältnisses zuerst auf/eine niedrigere Frequenz springen, um anschließend durch den Regelvorgang wieder enger zusammenzurücken. Zu einem durch eine Klammer 12 gekennzeichneten Zeitpunkt stimmt die Frequenz der Impulse 8 schon mit der Frequenz des Referenzsignals überein. Bezüglich der Phase herrscht jedoch noch eine Abweichung. Diese Abweichung kann nur dadurch behoben werden, daß das Signal des Oszillators 1 über den eigentlich gewünschten Wert hinaus kurzzeitig erhöht wird. Aus diesem Grunde setzen sich die Impulse am Ausgang 9 « aufwärts » auch noch weiter fort. Die bekannte Schaltung weist also ein systembedingtes Überschwingen auf.

In Fig. 3 ist ein Impulsdiagramm dargestellt, bei dem zum Zeitpunkt to das Teilungsverhältnis des programmierbaren Teilers 2 in Fig. 1 auf einen kleineren Wert eingestellt wird. Die Zeit, zu der bereits Übereinstimmungen bezüglich der Frequenz der im Phasendiskriminator 3 verglichenen Signale herrscht, ist durch eine Klammer 13 gekennzeichnet.

Die in Fig. 1 mit 7 bezeichnete Hilfsschaltung dient dazu, den programmierbaren Teiler 2 beziehungsweise die Referenzfrequenzquelle 4 zu bestimmten Zeitpunkten in ihre Ausgangsstellung zurückzusetzen. Die Hilfsschaltung 7 wird von den Signalen der Ausgänge 9 und 10 des Phasendiskriminators 3 gesteuert.

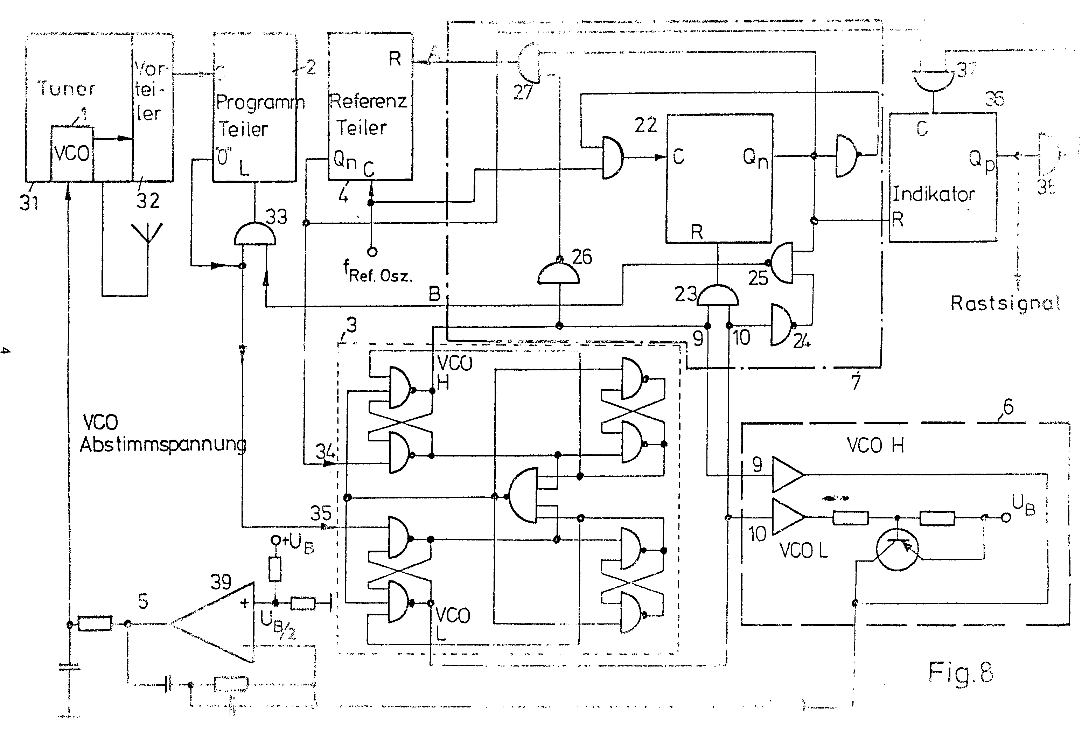

In den Figuren 4 und 5 ist gezeigt, wie die Hilfsschaltung 7 in Fig. 1 beispielsweise auf den programmierbaren Teiler 2 und die Referenzfrequenzquelle 2 einwirken kann. In Fig. 4 wird entsprechend Fig. 2 von einer Änderung der Frequenz des Oszillators in Aufwärtsrichtung ausgegangen. Es ist bei der Darstellung vorausgesetzt, daß die Schaltung die gleichen Bestandteile aufweist wie diejenige Schaltung, die bei den Figuren 2 und 3 zugrundegelegt wurde, jedoch zusätzlich die Hilfsschaltung 7.

In der Hilfsschaltung 7 wird ein in der letzten Zeile der Figur 4 dargestelltes Synchronisiersignal A gebildet. Das Synchronisiersignal A enthält Impulse, z. B. 14 und 17, die dem Reset-Eingang der Referenzfrequenzquelle zugeführt sind. Zum Zeitpunkt to wird ein neues Teilungsverhältnis eingegeben und zum Zeitpunkt $t_1$ beginnt der Oszillator seine Frequenz zu erhöhen, so daß die Impulse 8 wieder näher zusammenrücken. Zum Zeitpunkt $t_1$ wird am Ausgang 9 « Aufwärts » des Phasendiskriminators der Impuls 15 gestartet, da die Flanke 11 des Referenzsignals eher eintritt als der nächste Impuls 8 vom programmierbaren Teiler. Von dem Impuls 15 wird der Impuls 14 des Synchronisiersignals A abgeleitet. Mit dem Impuls 14 wird der Teiler der Referenzfrequenzquelle 4 in Fig. 1 zunächst zurückgesetzt und dann angehalten, so lange der Impuls 14 anliegt. Zum Zeitpunkt $t_2$ wird der Impuls 15 am Ausgang 9 durch den vom programmierbaren Teiler kommenden Impuls 8 beendet. Gleichzeitig wird auch der vom Impuls 15 abgeleitete Synchronisierimpuls 14 beendet. Zum Zeitpunkt $t_2$ wird somit der Teiler der Referenzfrequenzquelle 4 aus seiner Grundstellung heraus erneut gestartet. Nach der Periodendauer $T_1$ des Referenzsignals, zum Zeitpunkt $t_3$, beginnt am Ausgang 9 des Phasendiskriminators 3 ein neuer Steuerimpuls 16, da die Flanke 11 wiederum früher auftritt als der nächste Impuls 8 vom programmierbaren Teiler. Es wird wieder ein Synchronisierimpuls 17 abgeleitet, der den Teiler der Referenzfrequenzquelle 4 zurücksetzt und anhält. Die Regelung wird in der beschriebenen Weise fortgesetzt, bis zum Zeitpunkt $t_4$ die im Phasendiskriminator 3 verglichenen Signale bezüglich Frequenz und Phase übereinstimmen. Wie durch ein Vergleich der Figur 4 mit Figur 2 zu erkennen ist, wird dieser Zustand wesentlich schneller als bei der Schaltung ohne die Hilfsschaltung 7 erreicht. Der jeweils am Ende des Vergleichszyklusses beendete Steuerimpuls ist ein genaues Maß für die Frequenzabweichung der beiden am Phasendiskriminator anliegenden Signale, was bei den Figuren 2 und 3 nicht zutrifft.

Bei einer Änderung der Frequenz des Oszillators in der anderen Richtung (abwärts) wird in der Hilfsschaltung 7, wie in Fig. 5 dargestellt, ein Synchronisiersignal B von dem Ausgangssignal des Ausgangs 10 « abwärts » des Phasendiskriminators 3 abgeleitet. Mit diesem Synchronisiersignal B wird nicht wie in Fig. 4 die Referenzquelle 4, sondern der programmierbare Teiler 2 in ganz entsprechender Weise gesteuert.

Zum Zeitpunkt to wird wie bei Fig. 3 das Teilungsverhältnis des programmierbaren Teilers verkleinert entsprechend einer Herabsetzung der Frequenz des Oszillators 1. Dies bewirkt zunächst eine Erhöhung der Ausgangsfrequenz des steuerbaren Oszillators. Von den Impulsen, z. B. 18 und 19, des Ausgangs 10 « abwärts » des Diskriminators 3 wird das Synchronisiersignal B abgeleitet.

Dieses Signal wird gemäß Fig. 1 dem Load-Eingang des programierbaren Teilers 2 zugeführt. Zum Zeitpunkt $t_1$ wird durch einen Impuls 8 vom programmierbaren Teiler der Impuls 18 am Ausgang 10 gestartet. Durch den vom Impuls 18 abgeleiteten Synchronisierimpuls 20 wird der programmierbare Teiler gesetzt und bis Zeitpunkt $t_2$ in der Ausgangsstellung gehalten. Im Zeitpunkt $t_2$ wird durch die Flanke 11 des Referenzsignals der Impuls 18 beendet. Gleichzeitig beginnt der programmierbare Teile wieder zu arbeiten. Bei $t_3$ wird der Impuls 19 am Ausgang 10 begonnen, weil der nächste Impuls 8 früher erscheint als die nächste Flanke 11 des Referenzsignals. Durch den vom Impuls 19 abgeleiteten Synchronisierimpuls 21 wird wiederum der programmierbare Teiler 2 gesetzt und in seiner Ausgangsstellung gehalten. Zum Zeitpunkt $t_4$ wird der programmierbare Teiler 2 wieder freigegeben usw.

Wie sich aus den Ausführungen zu den Figuren 4 und 5 ergibt, wird in der einen Richtung die Referenzfrequenzquelle 4 und in der anderen Richtung der zwischen dem Oszillator und dem Diskriminator 3 liegende programmierbare Teiler 2 von der Hilfsschaltung beeinflußt. Die beeinflußte Schaltung wird in Abhängigkeit von den am Ausgang des Diskriminators auftretenden Signalen, die ein Maß für den Phasen- bzw. Frequenzfehler darstellen, so gesteuert, daß zu Beginn eines jedes Vergleichszyklusses der Phasenfehler Null angenommen wird. Auf diese Weise wird eine Regelung über den gewünschten Wert hinaus vermieden. Die beschriebene Phasenregelschaltung mit der Hilfsschaltung 7 weist damit sehr kurze Einschwingzeiten auf.

In den Figuren 4 und 5 ist dargestellt, daß die ansteigende Flanke des Synchronisiersignals A bzw. B gegenüber der Flanke des zugehörigen Ausgangssignals des Diskriminators 3 um die Zeit $\tau$ versetzt ist. Durch Vorgabe einer bestimmten Verzögerungszeit $\tau$ kann erreicht werden, daß die Hilfsschaltung nur bis zu einer bestimmten Mindestbreite der Impulse des Ausgangssignals des Diskriminators 3 wirksam ist. Wenn die Impulse an den Ausgängen 9 und 10 des Diskriminators 3 die Mindestbreite unterschreiten, werden keine Synchronisiersignale A bzw. B mehr erzeugt. Die Schaltung arbeitet dann in der gewohnten Weise, wie bei den Figuren 2 und 3 beschrieben. Die Verzögerungszeit wird vorteilhaft größer als eine Periode der Frequenz des Referenzoszillators gewählt, damit die Hilfsschaltung im eingeschwungenen Zustand nicht anspricht.

Die Regelschaltung wird, wenn die genannte Verzögerungszeit vorgesehen ist, mittels der Hilfsschaltung 7 zur Vermeidung eines Überschwingens an den Zustand herangeführt, in dem die am Phasendiskriminator anliegenden Signale sowohl bezüglich der Frequenz als auch der Phase übereinstimmen. Danach ist die Hilfsschaltung 7 unwirksam.

In Fig. 6 ist dargestellt, welche Wirkung mit der Hilfsschaltung 7 erreicht wird. Es ist das Signal wiedergegeben, mit dem der Oszillator 1 in Fig. 1 gesteuert wird. In Fig. 6 oben ist der Verlauf dieses Signales bei einer Frequenzerhöhung dargestellt, das gemessen wurde, wenn eine Hilfsschaltung vorgesehen ist, die in der beschriebenen Weise arbeitet. Das Signal in Fig. 6 unten wurde gemessen, als die gleiche Schaltung ohne die Hilfsschaltung 7 verwendet wurde. Es ist zu erkennen, daß durch die Hilfsschaltung 7 eine wesentliche Verbesserung des Einschwingverhaltens erreicht wird.

Fig. 7 zeigt ein Ausführungsbeispiel der Hilfsschaltung 7 in Fig. 1. Die Hilfsschaltung ist mit einem Zähler 22 und logischen Gattern 23 bis 27 aufgebaut. Der Zähler dient zur Gewinnung der festen Verzögerungszeit $\tau$. Die Signale an den Ausgängen 9 und 10 des Phasendiskriminators 3 in Fig. 1 sind in Fig. 7 über ein UND-Gatter 23 dem Reset-Eingang des Zählers 22 zugeführt. Dem Takteingang des Zählers 22 sind über eine Eingangsklemme 30 Zähltakte mit einer Frequenz von z. B. 1 MHz zugeführt. Wenn von den Ausgängen 9 und 10 des Phasendiskriminators kein Impuls kommt, so erhält der Reset-Eingang ein Resetsignal und die Taktimpulse am Takteingang des Zählers 22 sind unwirksam. Der Ausgang $Q_n$ der n-ten Stufe des Zählers 22 ist mit einem sogenannten Disable-Eingang des Zählers 22 verbunden. D. h., wenn der Zählerstand $Q_n$ erreicht wird, hält der Zähler sich selbst an. Von dem Ausgang $Q_n$ werden über die Gatter 25 und 27 außerdem die Synchronisiersignale A und B abgeleitet. Über Inverter 24 und 26 wird den als Torschaltungen arbeitenden Gattern 25 und 27 vom Eingang der Hilfsschaltung ein Signal zugeführt, durch das vorgegeben wird, welches der beiden Gatter 25 und 27 für das vom Ausgang $Q_n$ kommende Signal durchlässig sein soll. Mittels der Gatter 25 und 27 wird also gesteuert, ob der programmierbare Teiler 2 oder die Referenzfrequenzquelle 4 in Fig. 1 ein Synchronisiersignal erhält.

Die Schaltung in Fig. 7 arbeitet folgendermaßen : (Es wird auf die Figuren 4 und 5 Bezug genommen.) Der Impuls 15 in Fig. 4 liegt am Eingang 9 und bereitet über den Inverter 26 das Tor 27 für ein Synchronisiersignal vor. Es erscheint am Ausgang 29 jedoch noch kein Impuls, da der Ausgang $Q_n$ des Zählers 22 noch kein Signal liefert. Durch den Impuls 15 wird das Resetsignal des Zählers 22 aufgehoben und es werden Zähltakte vom Eingang 30 in den Zähler eingezählt. Nach einer Verzögerungszeit $\tau$ erscheint, abhängig von der Taktfrequenz und der Anzahl der Stufen des Zählers, am Ausgang $Q_n$ ein Signalsprung, durch den der Zähler 22 über den Disable-Eingang angehalten wird. Durch den Signalwechsel am Ausgang $Q_n$ wird außerdem der logische Zustand am oberen Eingang des Gatters 27 geändert, wodurch der Impuls 14 in Fig. 4 gebildet wird. Sobald der Impuls 15 in Fig. 4 beendet ist, ist die UND-Bedingung für das Tor 27 nicht mehr erfüllt, so daß der Impuls 14 gleichzeitig mit dem Impuls 15 beendet wird.

Durch die Beendigung des Impulses 15 wird der Zähler 22 wieder in seine Ausgangsstellung zurückgesetzt und in dieser Stellung gehalten.

Bei einem Impuls am Eingang 10 der Schaltung in Fig. 7 arbeitet die Schaltung entsprechend jedoch mit dem Unterschied, daß das Tor 25 anstelle des Tores 27 geöffnet wird. In diesem Fall wird also am Ausgang 28 das Synchronisiersignal B gebildet. Mit dem Signal B wird gemäß Fig. 1 der programmierbare Teiler 2 gesteuert.

Durch eine bestimmte Wahl der Frequenz des Zähltaktes am Eingang 30 kann die Verzögerungszeit τ vorgewählt werden.

Es ist auch möglich, die Verzögerungszeit τ durch anders arbeitende Schaltelemente zu gewinnen. Z. B. kann die Verzögerungszeit mehrerer hintereinander geschalteter Gatter (z. B. Inverter) ausgenutzt werden.

Fig. 8 zeigt ein Gesamtschaltbild eines Tuners, der mit der Phasenregelschaltung mit den Merkmalen der Erfindung aufgebaut ist. Oben links in Fig. 1 ist als Block ein Tuner 31 dargestellt mit dem VCO 1. Das Signal des VCO 1 gelangt über einen im Tuner enthaltenen Vorteiler 32 zum programmierbaren Teiler 2. Der programmierbare Teiler wird zu Beginn eines Teilungszyklusses auf den vorprogrammierten Wert über einen Eingang « Load » eingestellt und dann bis zum Wert Null getaktet. Mit Erreichen des Wertes Null erhält der Load-Eingang über ein Gatter 33 einen neuen Ladeimpuls, durch den die Ausgangsstellung des programmierbaren Teilers 2 erneut eingestellt wird. Der Ladeimpuls des programmierbaren Teilers ist dem einen Eingang 35 des in Fig. 8 gestrichelt umrahmten Phasendiskriminators 3 zugeführt. Der andere Eingang 34 des Phasendiskriminators 3 erhält ein Signal von Referenzteiler 4. Der Phasendiskriminator 3 ist in an sich bekannter Weise mit N-Gatter aufgebaut. Unten rechts in Fig. 8 ist der Aufbau der Verknüpfungsschaltung 6 wiedergegeben. Die bereits anhand von Fig. 7 beschriebene Hilfsschaltung 7 ist in Fig. 8 umrahmt. das Synchronisationssignal A ist auf den Reset-Eingang des Referenzteilers 4 geführt und das Synchronisationssignal B auf das schon erwähnte Gatter 33.

Mit der Hilfsschaltung 7 ist ein Lock-Indikator (Einrastindikator) verbunden, der mit einem Zähler 36, einem UND-Gatter 37 und einem Inverter 38 aufgebaut ist. Der Zähler 36 wird mit jedem Synchronisiersignal A oder B über einen Reset-Eingang zurückgesetzt. Über ein UND-Gatter 37 werden dem Clock-Eingang des Zählers 36 Taktimpulse mit einer relativ niedrigen Frequenz zugeführt. Diese Taktimpulse werden dem Ausgang des Referenzteilers 4 entnommen. Von einem Ausgang $Q_p$ wird ein Locksignal abgeleitet. Dieses Locksignal erscheint nur, wenn über eine längere Zeit kein Synchronisiersignal mehr erscheint. Die Zufuhr von Taktimpulsen über das Gatter 37 wird wegen einer Rückführung des Locksignals über einen Inverter 38 gesperrt, sobald das Locksignal erscheint. Das Locksignal steht so lange an, bis ein neues Synchronisiersignal gebildet wird.

Unten links in Fig. 8 ist eine Filterschaltung 5 gezeichnet, die mit einem Operationsverstärker

39 aufgebaut ist.

## Ansprüche

1. Digitale Phasenregelschaltung, bei der das Signal eines steuerbaren Oszillators (1) über einen programmierbaren Frequenzteiler (2) mit einem ersten Eingang eines Phasendiskriminators (3) und das Signal einer Referenzfrequenzquelle (4) über einen Frequenzteiler mit dem zweiten Eingang des Phasendiskriminators (3) verbunden sind und bei der in Abhängigkeit vom Ausgangssignal des Phasendiskriminators (3) der Oszillator (1) gesteuert wird und bei der eine vom Ausgang (9, 10) des Phasendiskriminators (3) gesteuerte Hilfsschaltung (7) vorgesehen ist, in der vom Ausgangssignal des Phasendiskriminators (3) im Fall eines Phasenfehlers ein Synchronisiersignal abgeleitet wird, mit dem der Teiler der Referenzfrequenzquelle (4) oder der programmierbare Teiler (2) in einen definierten Ausgangszustand setzbar sind, und bei der von dem Synchronisiersignal bei derjenigen Regelrichtung des Oszillators (1), bei der die Frequenz des Oszillators (1) abnimmt, der programmierbare Teiler (2) und bei der anderen Regelrichtung, bei der die Frequenz des Oszillators (1) zunimmt, der Teiler der Referenzfrequenzquelle (4) jeweils in den definierten Ausgangszustand gesetzt werden und bei der der in den Ausgangszustand gesetzte Teiler so lange in diesem Zustand gehalten wird, bis der andere, nicht beeinflußte Teiler seinen Ausgangszustand erreicht hat, wobei die jeweiligen Teiler (2, 4) in den definierten Ausgangszustand gesetzt werden, wenn das Signal am Ausgang (10) bzw. am Ausgang (9) des Phasendiskriminators (3) größer als eine Referenzzeit (τ) ist, während im Fall, daß das Signal am Ausgang (10) bzw. am Ausgang (9) des Phasendiskriminators (3) kleiner als die Referenzzeit ist, kein Setzen in den definierten Ausgangszustand erfolgt, wofür von Impulsen des Ausgangssignals des Phasendiskriminators (3) das Synchronisiersignal darstellende Impulse abgeleitet werden, dadurch gekennzeichnet, daß deren Vorderflanke um die Referenzzeit (τ) gegenüber der Vorderflanke der Impulse des Ausgangssignales des Phasendiskriminators versetzt sind und deren Rückflanken mit den Rückflanken der Impulse des Ausgangssignales des Phasendiskriminators übereinstimmen, daß die Referenzzeit (τ) fest ist und von einer separat aufgebauten Zeitgeberschaltung bestimmt wird, und daß diese Referenzzeit (τ) derart bemessen ist, daß die Einschwingung nach einer Neueinstellung des Teiler möglichst schnell, aber ohne Überschwingen vorgeht.

2. Phasenregelschaltung nach Anspruch 1, dadurch gekennzeichnet, daß die Zeitgeberschaltung zur Bildung der Referenzzeit (τ) mit einen Zähler (22) aufgebaut ist, dem Zähltakte konstanter Frequenz zugeführt sind, daß der Zähler beim Auftreten eines Impulses an Ausgang des Phasendiskriminators für eine Zählung der Zähltakte aus seiner Grundstellung heraus freigegeben wird, daß ein bei einem bestimmten Zählerstand am Ausgang des Zählers auftretendes Sperrsignal auf einen Sperreingang des Zählers zurückgeführt ist und daß von dem Sperrsignal das Synchronisiersignal abgeleitet ist.

3. Phasenregelschaltung nach Anspruch 2, gekennzeichnet durch folgende weitere Merkmale :

a) der Phasendiskriminator weist einen ersten Ausgang (9) auf, an dem Impulse bei einer Regelung in Aufwärtsrichtung auftreten, und einen zweiten Ausgang (10), an dem Impulse bei einer Regelung in Abwärtsrichtung auftreten,

b) die Hilfsschaltung weist eine Verknüpfungsschaltung (23) auf, deren Eingängen die Impulse der Ausgänge des Phasendiskriminators (3) zugeführt sind und deren Ausgang mit dem Rücksetzeingang des Zählers (22) verbunden ist,

c) das Sperrsignal des Zählers ist über eine erste Torschaltung (27) dem Rücksetzeingang der Referenzfrequenzquelle (4) und über eine zweite Torschaltung (25) dem Steuereingang (L) des programmierbaren Teilers (2) zuführbar,

d) mit den Impulsen des ersten Ausganges (9) des Phasendiskriminators (3) wird die erste Torschaltung (27) gesteuert und mit den Impulsen des zweiten Ausganges (10) des Phasendiskriminators (3) die zweite Torschaltung (25).

**Claims**

1. Digital phase control circuit in which the signal from a controllable oscillator (1) is connected by way of a programmable frequency divider (2) with the first input of a phase discriminator (3) and the signal of a reference frequency source (4) is connected by way of a frequency divider with the second input of the phase discriminator (3) ; in which the oscillator (1) is controlled in dependence upon the output signal of the phase discriminator (3) ; in which an auxiliary circuit (7) is provided, controlled by the output (9, 10) of the phase discriminator (3), in which auxiliary circuit a synchronising signal is derived from the output signal of the phase discriminator (3) in the event of a phase error, by which the divider of the reference frequency source (4) or the programmable divider (2) can be set in predetermined output state ; in which on the occurrence of that control direction of the oscillator (1) in which the frequency of the oscillator (1) diminishes, the programmable divider (2) is set in the predetermined output state by the synchronising signal, and on the occurrence of the other control direction, in which the frequency of the oscillator (1) increases, the divider of the reference frequency source (4) is respectively set in the predetermined output state by the synchronising signal ; in which the divider which has been set in the output state is held in that state until the other non-influenced divider has attained its output state, the arrangement being such that the respective dividers (2, 4) are set in the predetermined output states if the signal at the output (10) or respectively at the output (9) of the phase discriminator (3) exceeds a reference time (τ), whereas in the event that the signal at the output (10) of the discriminator (3) is smaller than the reference time, no setting up of the predetermined output state takes place, with which in view, impulses, performing as the synchronising signal, are derived from impulses of the output signal of the phase discriminator (3), characterized in that the leading edges of said derived impulses are displaced by the reference time (τ) with respect to the leading edges of the impulses of the output signal of the phase discriminator and the trailing edges thereof coincide with the trailing edges of the impulses of the output signal of the phase discriminator, and that the reference time (τ) is so calculated that the swing toward a new setting of the divider occurs as quickly as possible but without overswings.

2. Phase discriminator according to claim 1, characterized in that the timing circuit for establishing the reference time (τ) is constructed with a counter (22) to which are applied counting pulses of constant frequency, the counter is released from its ground state to perform a count of the counting pulses by the appearance of an impulse at the output of the phase discriminator, a blocking signal, which appears on the occurrence of a predetermined counter state at the output of the counter, is fed back to a blocking input of the counter, and the synchronising signal is derived from the blocking signal.

3. Phase discriminator circuit according to Claim 2, characterised by the following additional features :

a) the phase discriminator has a first output (9) at which impulses appear in the event of a control in the upward direction, and a second output (10) at which impulses appear in the event of a control in the downward direction,

b) the auxiliary circuit has a combining circuit (23), to inputs of which are applied the impulses from the outputs of the phase discriminator (3) and the output of which is connected with the restoring input of the counter (22),

c) the blocking signal of the counter can be conducted by way of a first gate circuit (27) to the restoring input of the reference frequency source (4) and by way of a second gate circuit (25) to the control input (1) of the programmable divider (2),

d) the first gate circuit (27) is controlled by the impulses of the first output (9) of the phase discriminator (3) and the second gate circuit (25) is controlled by the impulses of the second output (10) of the phase discriminator (3).

**Revendications**

1. Boucle de phase numérique dans laquelle le signal d'un oscillateur asservi (1) est relié par un diviseur de fréquence programmable (2) à une première entrée d'un discriminateur de phase (3) et le signal d'une source de fréquence de référence (4) est relié par un diviseur de fréquence à la seconde entrée du discriminateur de phase (3) ; l'oscillateur (1) est commandé en fonction du signal de sortie du discriminateur de phase (3) ; un circuit auxiliaire (7), commandé par la sortie (9, 10) du discriminateur de phase (3), délivre à partir du signal de sortie de ce dernier, dans le cas d'une erreur de phase, un signal de synchronisation permettant d'amener le diviseur de la source de fréquence de référence (4) ou le diviseur programmable (2) dans un état initial défini ; le signal de synchronisation amène dans l'état initial défini le diviseur programmable (2) pour le sens de régulation de l'oscillateur (1) dans lequel sa fréquence diminue, et le diviseur de fréquence de référence (4) pour l'autre sens de régulation, dans lequel la fréquence de l'oscillateur (1) augmente ; et le diviseur amené dans l'état initial y est maintenu jusqu'à ce que l'autre diviseur, non influencé, atteigne son état initial, les diviseurs (2, 4) étant amenés chacun dans l'état initial défini quand le signal sur la sortie (10) ou la sortie (9) du discriminateur de phase (3) est supérieur à un temps de référence ($\tau$), tandis qu'il n'y a pas de passage à l'état initial défini quand le signal sur la sortie (10) ou la sortie (9) du discriminateur de phase (3) est inférieur au temps de référence, des impulsions qui représentent le signal de synchronisation étant pour ce faire produites à partir d'impulsions du signal de sortie du discriminateur de phase (3), ladite boucle étant caractérisée en ce que les flancs avant des impulsions du signal de synchronisation sont décalés du temps de référence ($\tau$) par rapport aux flancs avant des impulsions du signal de sortie du discriminateur de phase et leurs flancs arrière coïncident avec ceux des impulsions du signal de sortie du discriminateur de phase, le temps de référence ($\tau$) est fixe et déterminé par une horloge distincte ; et ce temps de référence ($\tau$) est dimensionné de façon que le régime transitoire suivant un nouveau réglage du diviseur soit aussi bref que possible, mais s'effectue sans dépassement.

2. Boucle de phase selon revendication 1, caractérisée en ce que l'horloge délivrant le temps de référence ($\tau$) est réalisée avec un compteur (22) auquel sont appliquées des impulsions de comptage à fréquence constante ; le compteur est libéré pour un comptage desdites impulsions, à partir de sa position de base, lors de l'apparition d'une impulsion à la sortie du discriminateur de phase ; un signal de blocage, apparaissant à la sortie du compteur pour une indication déterminée de ce dernier, est ramené sur une entrée de blocage du compteur ; et le signal de synchronisation est dérivé du signal de blocage.

3. Boucle de phase selon revendication 2, caractérisée en ce que :

a) le discriminateur de phase comporte une première sortie (9), sur laquelle apparaissent des impulsions pour une régulation dans le sens croissant, et une seconde sortie (10), sur laquelle apparaissent des impulsions pour une régulation dans le sens décroissant ;

b) le circuit auxiliaire comprend un circuit logique combinatoire (23), dont les entrées reçoivent les impulsions des sorties du discriminateur de phase (3) et dont la sortie est reliée à l'entrée de remise à 0 du compteur (22) ;

c) le signal de blocage du compteur est ramené par un premier opérateur (27) sur l'entrée de remise à 0 de la source de fréquence de référence (4) et par un second opérateur (25) sur l'entrée de commande (1) du diviseur programmable (2) ; et

d) le premier opérateur (27) est commandé par les impulsions de la première sortie (9) et le second opérateur (25) par les impulsions de la seconde sortie (10) du discriminateur de phase (3).

Fig.1

mit Hilfsschaltung

Fig.6

ohne Hilfsschaltung

Fig. 7

0 012 899

programmierb.Teiler

Referenzsignal

Ausgang "aufwärts"

Ausgang "abwärts"

## Fig.2

programmierb.Teiler

Referenzsignal

Ausgang "aufwärts"

Ausgang "abwärts"

Fig.3

Fig. 4

Fig. 5

Fig.8